# EUROPEAN PATENT APPLICATION

(11) **EP 3 680 819 A1**
(43) Date of publication of application: **15.07.2020**
(21) Application number: 19151335.7
(22) Date of filing: 11.01.2019
(51) Int. Cl.: G06K 9/46, G06N 3/02, G01R 33/48

(54) **FAT SUPPRESSED MAGNETIC RESONANCE IMAGING**

(71) Applicant: Koninklijke Philips N.V., 5656 AG Eindhoven (NL)
(72) Inventor: SOMMER, Karsten, 5656 AE Eindhoven (NL); BOERNERT, Peter, 5656 AE Eindhoven (NL)
(74) Representative: de Haan, Poul Erik

(57) **Abstract**

The present invention relates to training a fully convolutional neural network (210) for identifying fat pixels in magnetic resonance images (200) and using the trained fully convolutional neural network (210) for suppressing fat in magnetic resonance images (200). The fully convolutional neural network (210) is trained with magnetic resonance images including fat pixels (200) and corresponding magnetic resonance images with suppressed fat pixels for generating magnetic resonance images with identified fat pixels (220) as output. The trained fully convolutional neural network (210) generates magnetic resonance images with identified fat pixels (220) based on input magnetic resonance images (200). The magnetic resonance images with identified fat pixels (220) are subtracted from the input magnetic resonance images (200) in order to generate fat suppressed magnetic resonance images (240). This allows improving the image quality and contrast while not increasing total scan time by efficiently suppressing fat in post processing.

## Description

### FIELD OF THE INVENTION

The present invention relates to a method for training a fully convolutional neural network (FCN) for identifying fat pixels in magnetic resonance (MR) images, a method for suppressing fat using the trained FCN in MR imaging (MRI), an image processing product for generating fat suppressed magnetic resonance images using the trained FCN in MRI, and an MRI system using the image processing product for generating fat suppressed MR images.

### BACKGROUND OF THE INVENTION

The article "Separation of Water and Fat Magnetic Resonance Imaging Signals Using Deep Learning with Convolutional Neural Networks" by James W. Goldfarb, Magnetic Resonance in Medicine, arXiv: 1711.00107v1, shows a method for magnetic resonance imaging water-fat separation using a U-Net convolutional neural network (CNN) and deep learning (DL). The U-Net CNN is trained with complex or magnitude-only gradient-echo cardiovascular images and conventional model-based water-fat reconstructions for calculation of water-only, fat-only, R₂* and off-resonance images.

### SUMMARY OF THE INVENTION

It can be seen as an object of the present invention to provide a method for training a FCN for identifying fat pixels in MR images, a method for suppressing fat in MR images using the trained FCN in MRI, an image processing product for generating fat suppressed MR images using the trained FCN in MRI, and an MRI system using the image processing product for generating fat suppressed MR images, which allow to suppress fat in MRI with high reliability.

In a first aspect of the present invention a method for training a FCN for identifying fat pixels in MR images is presented. The method comprises the steps:
- providing a training set of MR images including fat pixels and corresponding MR images with suppressed fat pixels, and
- training the FCN with the training set as input such that the FCN generates MR images with identified fat pixels as output.

Using the trained FCN on input MR images allows to improve the image quality while not increasing the total scan time as fat can be efficiently suppressed in a post processing step of the MR image generation. In contrast to fat suppression methods using magnetization preparation, such as spectrally adiabatic inversion recovery (SPAIR), short inversion time inversion recovery (STIR), spectral spatial excitation in which protons of water are selectively stimulated while protons of fat molecules are not, or spectral presaturation with inversion recovery (SPIR), a more complete fat suppression is possible. Furthermore, Bo- and B₁⁺-field inhomogeneities have a weaker effect on the fat suppression obtained using the FCN. The FCN can identify fat pixels in thin slices and is less affected by areas of bad shim. In contrast to fat suppression methods that rely on chemical shift information or appropriate encoding, no additional scan time is required and higher compatibility to different MR sequences is provided.

The MR images including fat pixels correspond to MR images of an anatomy as acquired using MRI. The corresponding MR images with suppressed fat pixels correspond to corresponding MR images of the same anatomy with suppressed fat pixels. The slices of the MR images including fat pixels and the slices of the corresponding MR images with suppressed fat pixels are identical.

The FCN is used for a pixel-wise regression task, allowing to predict what is in the respective input image and where it is in the respective input image. The FCN allows to input MR images of arbitrary size and produces correspondingly-sized output images with predicted fat intensity. Identifying the fat pixels means predicting a fat intensity for the pixels of the MR images.

The FCN comprises only locally connected layers, such as convolutional layers, pooling layers, upsampling layers, and transposed convolutional layers, i.e., the FCN does not include a fully connected layer in which each neuron of one layer is connected to each neuron of another layer. This allows to reduce the number of parameters and the computation time. Furthermore, the FCN can include skip connections between layers which bypass at least one layer. This allows to retain high resolution information. The FCN can also include one or more deconvolution layers or transposed convolutional layers. This allows upsampling of scores to the dimensions of the respective input image. The FCN can also be a multi-scale network.

Various architectures for the FCN can be chosen. The FCN can for example be the F-Net as presented in T. Brosch and A. Saalbach, "Foveal Fully Convolutional Nets for Multi-Organ Segmentation", published in Proceedings Volume 10574, Medical Imaging 2018: Image Processing; 105740 U (2018), which is incorporated herein by reference. The FCN can alternatively for example be one of the FCN-32s, FCN-16s, or FCN-8s as presented in J. Long et al., "Fully Convolutional Networks for Semantic Segmentation" published as arXiv:1411.4038v2, which is incorporated herein by reference. The FCN can also be an adapted AlexNet, VGG net, GoogLeNet, or other CNN architecture adapted to an FCN, i.e., FCN-AlexNet, FCN-VGG16, or FCN-GoogLeNet as presented in J. Long et al., "Fully Convolutional Networks for Semantic Segmentation", published as arXiv:1411.4038v2, which is incorporated herein by reference. The FCN can also for example be the U-Net as presented in O. Ronneberger et al., "U-Net: Convolutional Networks for Biomedical Image Segmentation", published as arXiv.1505.04597v1, which is incorporated herein by reference. The FCN can alternatively be adapted based on another convolutional neural network (CNN), such as for example one of the previously mentioned CNNs and FCNs. It is also possible to generate FCNs with various architectures and select the FCN optimized for the MR sequence used for generating the MR images.

The MR images with suppressed fat pixels can be subtracted from the corresponding MR images including fat pixels in order to generate a training set of reference fat-only MR images. An objective function of the FCN can be optimized by increasing a similarity between the reference fat-only MR images of the training set and the MR images with identified fat pixels generated by the FCN as output.

The objective function, e.g. a loss function, cost function, utility function, or fitness function, represents the similarity between the output MR image of the FCN and the MR image generated by the difference of the MR image with fat pixels and the corresponding MR image with suppressed fat pixels, i.e., the reference fat-only MR image. The objective function can for example use the mean-squared-error (MSE) between the output MR image of the FCN and the reference fat-only MR image for representing the similarity of the images.

Weights of the FCN can be initialized randomly, transferred from another task, or can be provided in any other manner.

Stochastic gradient descent (SGD) or another optimization method can be used for optimizing the weights of the FCN to optimize the objective function.

The MR images with suppressed fat pixels can be generated by acquiring the MR images with a fat suppression method. Fat suppression methods can include SPAIR, SPIR, STIR, Dixon methods, and/or any other fat suppression method. Different MR images of the same anatomy can be acquired for the training set. The training set of the MR images can be optimized by inspecting the MR images with suppressed fat pixels and by excluding MR images for which the fat suppression was only partially successful, i.e., MR images which include residual fat. Different fat suppression methods can be used in order to ensure that residual fat is as low as possible in the MR images of the training set.

Alternatively, the training set can be generated based on chemical shift encoding based methods in order to separate water and fat. The resulting fat-only MR images can be used for training the FCN as reference fat-only MR images.

The training set can include MR images including residual fat pixels that have been generated by a fat suppression method and corresponding MR images without fat pixels. This allows to acquire MR images using conventional fat suppression methods, such as STIR, SPIR, SPAIR, or the like, and post process them with the FCN for eliminating residual fat pixels from the MR images as generated by the conventional fat suppression methods. MR images without fat pixels can for example be acquired based on manual selection of MR images generated by a conventional fat suppression method.

The training set can include MR images generated by data augmentation and/or artificially generated MR images. This means the training set can include MR images generated by data augmentation, artificially generated MR images, or MR images generated by data augmentation and artificially generated MR images. The size and variability of the training set can be increased by using data augmentation, such as random translations, rotations, and deformations of the MR images. The size and variability of the training set can additionally or alternatively be increased by artificially generating MR images with different amount of noise, contrast variations, and/or geometry distortions, e.g., using a MR image simulation tool such as JEMRIS as presented in Stöcker et al. "High-performance computing MRI simulations", published in Magnetic Resonance in Medicine (2010), 64(1), 186-193, which is herein incorporated by reference. The size and variability of the training set can furthermore be increased based on other confounding factors such as for example B₀ field maps, if the respective MR sequence used for generating the MR images is sensitive to the confounding factors.

The training set can include at least two different versions of the same MR image with two different resolutions. The training set can for example include a full-resolution version of the MR images and half- and/or quarter-resolution versions of the same MR images. The information from these different input MR images can be combined towards the final layers of the FCN. This approach is also called multi-scale approach. Training the FCN with different versions of the same MR images with different resolutions for example allows to provide a theoretical receptive field (TRF) size that is larger than a water fat shift (WFS) with for example relatively small convolutional kernels and relatively few layers.

Alternatively or additionally, the training set can include MR images with different contrasts. This allows efficiently generating MR images with identified fat pixels for several different MR sequences, such as for example for diffusion MRI, functional MRI (fMRI) or other MR sequences with varying contrasts. The training set can for example be generated by quantitative measurements and synthetic MR methods.

The MR images of the training set can be complex-valued MR images, i.e., the MR images including fat pixels and the corresponding MR images with suppressed fat pixels can be complex-valued MR images. This allows to use the FCN to generate complex-valued MR images with identified fat pixels, which can be used for suppressing fat pixels in MR images including fat pixels by subtraction. For generating complex-valued MR images, for example real and imaginary part of the MR images can be stored or a simulation of the MR images can be performed using complex-valued arrays.

The method for training the FCN can be a batch learning method or an online learning method. The method can also first train the FCN based on batch learning and further optimize the weights of the FCN during online learning. This allows to further optimize the FCN during use of the FCN for suppressing fat in MR images. The method for training with online learning can comprise a step of providing MR images based on feedback from a user. This allows to re-train the FCN based on feedback from the user.

The MR images including fat pixels and the corresponding MR images with suppressed fat pixels can be directly derived from individual receive coils. The MR images with identified fat pixels of the individual receive coils generated as output of the FCN can be combined into MR images with identified fat pixels of an MRI system.

The MR images can be echo-planar images (EPI images) acquired using echo-planar imaging (EPI). The method can comprise the steps:
- providing EPI scan parameters used for acquiring the EPI images,
- calculating an absolute water-fat shift (WFS) in dependence of the EPI scan parameters, and
- providing the FCN with a theoretical receptive field (TRF) size in dependence of the calculated absolute WFS, such that the fat pixels and the physical location of the fat in the EPI images are covered by the TRF.

EPI is a MR imaging method that uses a train of gradient echoes with appropriate phase-encoding applied in parallel for acquiring an entire two-dimensional planar image in a single excitation (single shot EPI) or in a number of excitations (multi-shot EPI). EPI can be performed as a basic rapid gradient-echo (GRE) sequence or can be embedded in spin-echo (SE) or multiple gradient- and spin-echo sequences, such as Gradient And Spin Echo (GRASE). The fat is significantly shifted with respect to the water in EPI images in phase-encoding direction such that fat pixels overlay normal water tissue pixels. This WFS results as the electron probability density of the electrons of the hydrogen protons of water is shifted slightly more to the oxygen atom than for the hydrogen protons of the fat molecules resulting in a stronger shielding effect for the hydrogen protons in fat molecules compared to hydrogen protons in water. This shift is to be understood as a weighted average absolute WFS, as fat molecules have hydrogen protons in different configurations with different shielding effects. The absolute WFS can be calculated from the EPI scan parameters as a float number of pixels. The absolute WFS is typically on the order of several tenths of pixels and can for example be about 30, 40, or 50 pixels.

The TRF size corresponds to the region of input formed by any input pixel with an impact on an output unit of the FCN, i.e., a neuron of the final layer of the FCN. Since the FCN is provided with a TRF size in dependence of the calculated absolute WFS, such that the fat pixels and the physical location of the fat are covered by the TRF, detection of fat pixels is easier and more efficient. If the TRF size is too small, the FCN may not be able for identifying the fat pixels as replicas of pixels of anatomical structures located at other positions and thus may not correctly identify the fat pixels.

The TRF size is usually larger than an effective receptive field (ERF) size. The ERF size corresponds to the region of input formed by any input pixel with a non-negligible impact on an output unit of the FCN, e.g., as presented in W. Luo et al., "Understanding the Effective Receptive Field in Deep Convolutional Neural Networks", published as arXiv. 1701.04128v2, which is incorporated herein by reference. The ERF size can change during training and typically is closer to the TRF size after training than before training.

The method can comprise a step of providing the FCN with an ERF size in dependence of the calculated absolute WFS, such that the fat pixels and the physical location of the fat in the EPI images are covered by the ERF after training of the FCN. The pixels of the ERF can be defined to include the pixels of the TRF that have a value that is within one standard deviation, two standard deviations, three standard deviations, or any other predetermined value from a maximal value of the ERF.

Alternatively, the MR images can be acquired by any other type of MR sequence including SE sequences, inversion recovery sequences, GRE sequences, GRASE, diffusion weighted sequences, saturation sequences, spiral pulse sequences, Periodically Rotated Overlapping ParallEL Lines with Enhanced Reconstruction (PROPELLER) sequences, or any other types of MR sequence.

The FCN can be trained for identifying fat pixels in MR images depending on the MR sequence used for acquiring the MR images of the training set. Using various MR sequences allows to train the FCN for identifying fat pixels in various kinds of MR images. The MR images can be multi-dimensional images, e.g., three-dimensional images, diffusion-weighted images, or any other type of multi-dimensional image. This allows to leverage possible redundancies.

One or more hyperparameters of the FCN can be adapted such that the TRF size covers the fat pixels and the physical location of the fat in the EPI images. The one or more hyperparameters can include one or more of: convolutional kernels, strides, sub-samplings, dilation convolutions, skip connections, and/or types and number of layers of the FCN.

The TRF can be at least 50 % larger in phase-encoding direction than the calculated absolute WFS. The TRF can also be at least 40 % or at least 30 % larger in phase-encoding direction than the calculated absolute WFS. This allows to ensure that the fat pixels and the physical location of the fat are covered by the ERF. The TRF can for example be 30 pixels in phase-encoding direction for a calculated absolute WFS of 20 pixels.

At least two FCNs can be trained with different TRF sizes or at least one other different hyperparameter. The at least two FCNs can be considered for generating the MR images or EPI images with identified fat pixels. The at least two FCNs can be considered and one of them can be selected, e.g. based on MRI scan parameters or the EPI scan parameters, for generating the MR images or EPI images with identified fat pixels. Alternatively, the at least two FCNs can be used for generating averaged MR images or EPI images with identified fat pixels, e.g., by summing scores at each pixel of a respective MR image or EPI image generated by each of the FCNs and dividing by the number of FCNs. This allows to improve the identification of fat pixels.

In a further aspect of the present invention a method for suppressing fat in MR images is presented. The method comprises the steps:
- providing an input MR image as input to the FCN trained according to the method of claim 1 or any embodiment of the method for training the FCN,
- generating an MR image with identified fat pixels based on the input MR image using the FCN, and
- subtracting the MR image with identified fat pixels from the input MR image in order to generate a fat suppressed MR image.

This allows an efficient fat suppression during post processing of MR images.

The method for suppressing fat in MR images can include a step of displaying the fat suppressed MR image to a user.

The method for suppressing fat in MR images can include the steps:
- providing MRI scan parameters used for acquiring the input MR image,
- calculating an absolute WFS in dependence of the MRI scan parameters, and
- generating an MR image with identified fat pixels shifted to their physical location based on the MR image with identified fat pixels and the calculated absolute WFS. The method can furthermore include a step of adding the MR image with identified fat pixels shifted to their physical location and the fat suppressed MR image in order to generate a fat position corrected MR image. The method can include a step of displaying the fat position corrected MR image to the user.

The method for suppressing fat in MR images allows to suppress fat in MR images generated with different MR sequences by using a correspondingly trained FCN, i.e., using the FCN trained based on input MR images generated by the respective MR sequence.

In a further aspect of the present invention an MR image processing product for generating fat suppressed MR images is presented. The MR image processing product, comprises a FCN trained according to the method of claim 1 and a processor for generating MR images with identified fat pixels by applying the FCN on input MR images, and for subtracting the MR images with identified fat pixels from the input MR images in order to generate fat suppressed MR images. The MR image processing product can additionally or alternatively comprise a FCN trained according to the method of any of the dependent claims 1 to 10 or any other embodiment of the method for training the FCN.

The MR image processing product can comprise a memory for storing the FCN.

The MR image processing product can be configured to perform the method for suppressing fat in MR images according to claim 11 or any embodiment of the method for suppressing fat in MR images. The memory of the MR image processing product can store the method for suppressing fat in MR images according to claim 11 or any embodiment of the method for suppressing fat in MR images.

The MR image processing product can also be configured for generating fat position corrected MR images.

In a further aspect of the present invention an MRI system is presented. The MRI system comprises the MR image processing product according to claim 12 or any embodiment of the MR image processing product, and an MRI apparatus configured for generating the input MR images.

The MRI apparatus can be configured to provide the input MR images to the MR image processing product. The MRI apparatus can comprise:
- a main field magnet for generating a temporally constant magnetic field along a z-axis,
- gradient coils for generating magnetic fields along an x-axis, y-axis, and the z-axis,
- radio frequency coils for transmitting radio frequency signals and/or for receiving resulting MR signals, and
- a processing unit for generating the input MR images based on the received MR signals. Each of the x-axis, y-axis, and z-axis is perpendicular to the other two axes.

The MRI system can comprise a user interface configured for interacting with a user, e.g., displaying MR images, and receiving commands or feedback from the user. The MRI system can include a memory and/or a processor.

In a further aspect of the present invention a computer program product for generating fat suppressed MR images is presented. The computer program product comprises program code means for causing a processor to carry out the method as defined in claim 11 or any embodiment of the method, when the computer program product is run on the processor.

In a further aspect of the present invention a computer program product for training a FCN for identifying fat pixels in MR images is presented. The computer program product comprises program code means for causing a processor to carry out the method as defined in claim 1 or any embodiment of the method, when the computer program product is run on the processor.

In a further aspect a computer readable medium having stored the computer program product of claim 14 is presented. Alternatively or additionally the computer readable medium can have the computer program product according to any embodiment of the computer program product stored.

It shall be understood that the method of claim 1, the method of claim 11, the MR image processing product of claim 12, the MRI system of claim 13, the computer program product of claim 14, and the computer readable medium of claim 15 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
Fig. 1 shows schematically and exemplarily an embodiment of an MRI system with an MR image processing device for generating fat suppressed MR images;
Fig. 2 shows schematically and exemplarily a generation of a fat suppressed MR image using a trained FCN;
Fig. 3 shows schematically and exemplarily an embodiment of a method for training a FCN for identifying fat pixels in MR images;
Fig. 4 shows schematically and exemplarily an embodiment of a method for suppressing fat pixels in MR images using the trained FCN in MRI.

### DETAILED DESCRIPTION OF EMBODIMENTS

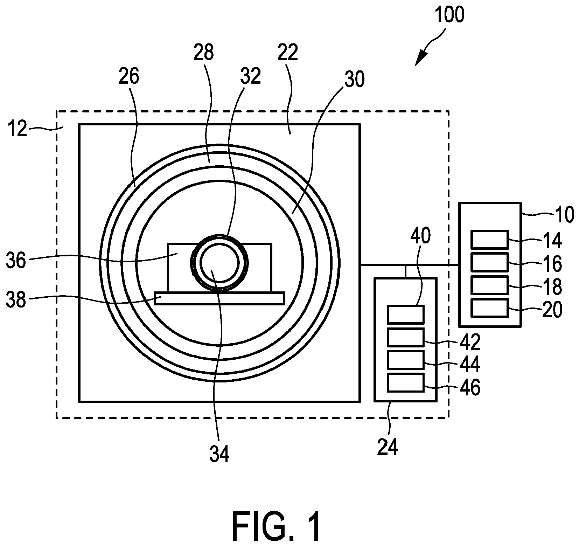

Fig. 1 shows schematically and exemplarily a first embodiment of an MRI system 100. The MRI system 100 in this embodiment is used for generating fat suppressed MR images. Suppression of fat is desirable to improve image quality and contrast. The MRI system 100 can be used for generating various types of MR images by using various types of MR sequences, such as SE sequences, inversion recovery sequences, GRE sequences, hybrids of multiple SE and GRE sequences dubbed, such as GRASE, diffusion weighted sequences, saturation sequences, spiral pulse sequences, PROPELLER sequences, or any other types of MR sequence. The MRI system 100 in this embodiment performs EPI for acquiring EPI images and suppresses fat pixels in the EPI images. In EPI the WFS is often so large that unsuppressed fat can mask important anatomical structures.

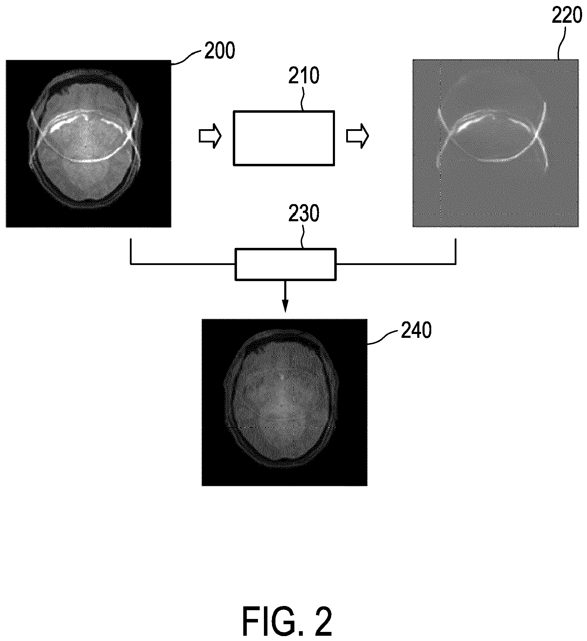

The MRI system 100 allows to provide fat suppressed EPI images 240 with improved image contrast without increasing total scan time for acquiring input EPI images 200 by using a trained FCN 210 for identifying fat pixels in the input EPI images 200 (cf. Fig. 2) and generating EPI images with identified fat pixels 220. The EPI images with identified fat pixels 220 are used for generating the fat suppressed EPI images 240 by subtracting the EPI images with identified fat pixels 220 from the EPI images 200 in a subtraction unit 230.

The MRI system 100 includes an MR image processing product 10 and an MRI apparatus 12 (cf. Fig. 1). The MRI apparatus 12 generates input EPI images. The MR image processing product 10 processes the EPI images generated by the MRI apparatus 12 and generates EPI images with identified fat pixels, as well as fat suppressed EPI images. In other embodiments the MR image processing product can additionally generate fat position corrected MR images. The MR image processing product can be included in the MRI apparatus in other embodiments.

The MR image processing product 10 includes a processor 14, a computer readable medium in form of memory 16, a transceiver 18, and a user interface 20.

The processor 14 generates the EPI images with identified fat pixels by applying the trained FCN for identifying fat pixels in EPI images on the input EPI images received from the MRI apparatus 12. The processor 14 subtracts the EPI images with identified fat pixels from the input EPI images in order to generate the fat suppressed EPI images.

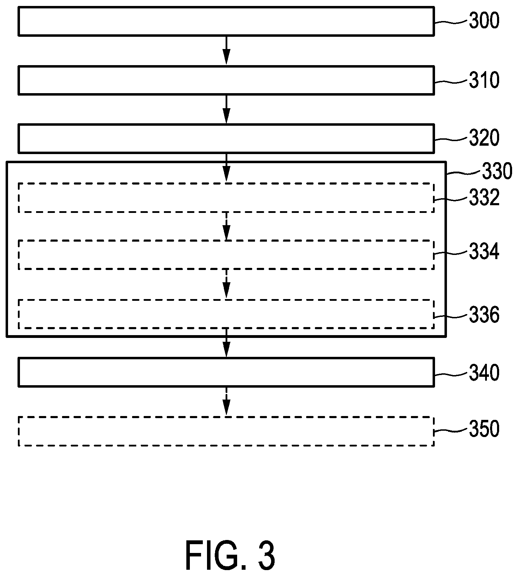

The trained FCN for identifying fat pixels in EPI images is stored in the memory 16. The FCN in this embodiment was trained according to the method presented in Fig. 3 for identifying fat pixels in EPI images. In other embodiments the FCN can also be trained by an alternative method, e.g., based on a training set of MR images including fat pixels and corresponding MR images with suppressed fat pixels generated by an alternative MR sequence, such that the FCN is trained for generating MR images with identified fat pixels for input MR images generated by the alternative MR sequence.

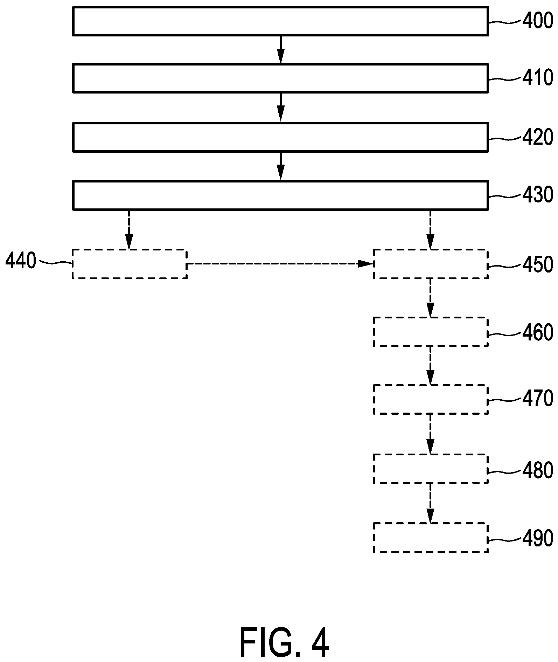

The memory 16 stores a computer program product for generating fat suppressed MR images with program code means for causing the processor 14 to carry out the method as presented in Fig. 4, when the computer program product is run on the processor 14. In other embodiments the memory 16 can also store an alternative computer program product with program code means for causing the processor 14 to carry out an alternative method for generating fat suppressed MR images. The memory can also store a computer program product for training a FCN for identifying fat pixels in MR images with program code means for causing the processor 14 to carry out the method as presented in Fig. 3 or any alternative method that generates MR images with identified fat pixels based on a training set of MR images including fat pixels and corresponding MR images with suppressed fat pixels, when the computer program product is run on the processor 14.

The transceiver 18 is used for wirelessly transmitting and receiving data, such as MR images including fat pixels, corresponding MR images with suppressed fat pixels, and MR images with identified fat pixels. Transmitting and receiving of data is also possible via a wired connection. In other embodiments the MRI system can have only a wireless or wired connection.

The user interface 20 displays the EPI images and can be used by a user of the MRI system 100 to control the MR image processing product 10. The user interface 20 and the transceiver 18 are optional.

The MRI apparatus 12 includes an acquisition unit 22 and a processing unit 24. The acquisition unit 22 includes a main field magnet 26, gradient coils 28, radio frequency (RF) coils 30, and receiving coils 32. In this embodiment the receiving coils 32 are arranged around a head 34 of a patient 36 arranged on a moveable table 38. In other embodiment other receiving coils can be provided for other anatomies and/or the RF coils can also be used for receiving MR signals. The processing unit 24 includes a processor 40, a memory 42, a transceiver 44, and a user interface 46.

The main field magnet 26 generates a temporally constant magnetic field along a z-axis. The gradient coils 28 generate magnetic fields along an x-axis, y-axis, and the z-axis. Each of the x-axis, y-axis, and z-axis is perpendicular to the other two axes. The RF coils 30 transmit RF signals to the head 34 of the patient 36 that is to be scanned when the patient 36 is moved inside of the magnetic fields generated by the main field magnet 26 and the coils 28 and 30 on the moveable table 38. The moveable table 38 is moveable along the z-axis for moving the patient 36 inside of the magnetic fields. The receiving coils 32 receive the resulting MR signals. The MR signals of the individual receiving coils 32 are transmitted to the processing unit 24.

The processing unit 24 generates the input EPI images for the FCN based on the received MR signals and controls the operation of the acquisition unit 22. The processing unit 24 transmits control signals to the acquisition unit 22 in order to perform various MR sequences for acquiring MR images. In this embodiment the processing unit 24 transmits control signals for performing EPI to the acquisition unit 22 for acquiring EPI images. Therefore, the control signal includes EPI scan parameters.

The memory 42 stores the input EPI images, MR sequences, and various sets of MRI scan parameters. Furthermore, the memory 42 stores program code means for performing various fat suppression methods, such as SPAIR, SPIR, STIR, and Dixon methods, or any other fat suppression method. The memory 42 also stores fat suppressed EPI images received from the MR image processing product 10. In other embodiments, the memory 42 can also store fat position corrected MR images.

The transceiver 44 wirelessly transmits and receives data. The transceiver 44 can be connected to a clinical information system for providing the EPI images and fat suppressed EPI images to a server. The clinical information system can also be used for remote control of the MRI system 100.

The user interface 46 displays EPI images and can be used by a user for providing commands and feedback. The transceiver 44 and the user interface 46 are optional.

Fig. 3 shows schematically and exemplarily an embodiment of a method for training a FCN for identifying fat pixels in MR images. In this embodiment the MR images are EPI images acquired using EPI. In other embodiments, the FCN can also be trained using any other kind of MR images generated by any different type of MR sequence instead of training the FCN with EPI images.

In step 300 EPI images including fat pixels are provided and included in a training set. The EPI images are acquired by a MRI system, for example the MRI system 100 as presented in Fig. 1 by using EPI.

In step 310 corresponding EPI images of the same anatomies with suppressed fat pixels are provided and included in the training set. The EPI images with suppressed fat pixels are generated by acquiring the EPI images with a fat suppression method. The EPI images with suppressed fat pixels can be acquired using an MRI system, e.g., the MRI system 100 as presented in Fig. 1 by using EPI and a fat suppression method. Fat suppression methods used for acquiring the EPI images with suppressed fat pixels include SPIR, SPAIR, STIR, Dixon's method, and any other method for suppressing fat in MR images. All acquired EPI images are manually inspected to exclude cases where the conventional fat suppression was only partially successful, i.e., where residual fat can be identified in the EPI image. In other embodiments chemical shift encoding based methods can be used for separating water and fat signals and fat-only EPI images can be used for training the FCN.

In order to increase the amount of EPI images in the training set additional EPI images are generated by data augmentation, e.g., translations, rotations, deformations, noise variations, contrast variations, or the like. In other embodiments artificially generated EPI images can be added to the training set additionally or alternatively. Instead of using EPI images any other kind of MR images acquired using other MR sequences can be artificially generated, e.g., using an MR simulation tool such as JEMRIS.

In this embodiment the training set includes various different versions of the same EPI image with different resolutions. Additionally, the training set also includes EPI images with different contrasts. In other embodiments the FCN can be trained with complex-valued MR images. In yet other embodiments the FCN can be trained based on the MR images acquired by individual receive coils and the output individual MR images with identified fat pixels can be combined afterwards to generate an MR image with identified fat pixels. In further embodiments the training set can include multi-dimensional datasets, such as three-dimensional MR images, diffusion-weighted MR images, or the like. This allows to leverage possible redundancies.

In other embodiments the training set can include EPI images including residual fat pixels that have been generated by a fat suppression method and corresponding EPI images without fat pixels. This allows to use the FCN in combination with conventional fat suppression methods.

In this embodiment the method for training the FCN is a batch learning method, i.e., a fixed training set is used for the training of the FCN before it is applied.

In other embodiments the training set can be continuously increased by adding EPI images to the training set, that are acquired during application of the FCN and the FCN can be trained online in an online learning method. Selection of EPI images for the training set can be based on user feedback. This allows to continuously improve the FCN by performing online learning.

Steps 300 and 310 can also be performed in parallel or in exchanged order.

In step 320, the EPI images with suppressed fat pixels are subtracted from the corresponding EPI images including fat pixels in order to generate a training set of reference fat-only EPI images.

In step 330, a FCN is provided. Various FCN architectures can be chosen, such as F-Net, FCN-32s, FCN-16s, FCN-8s, FCN-AlexNet, FCN-VGG16, FCN-GoogLeNet, or U-Net. In this embodiment a F-Net is used with two convolutional layers in each resolution level and three resolution levels with 32 channels for all convolutional layers. ReLU activation function is chosen as activation function. In other embodiments FCNs with various architectures are generated and provided to be trained in order to allow the selection of the trained FCN which provides the optimal results for the MR sequence used for generating the MR images used for the training and for the identification of the fat pixels. Step 330 includes the optional sub steps 332, 334, and 336.

In step 332, EPI scan parameters used for acquiring the EPI images are provided.

In step 334, an absolute WFS is calculated in dependence of the EPI scan parameters. The WFS of an EPI sequence is given by the chemical shift between water and fat in Hz divided by the bandwidth in phase-encoding direction in pixels per Hz. The WFS leads to a characteristic fat artifact appearance. The absolute WFS for EPI images is typically in the range of tenth of pixels, e.g., 30 pixels, 40 pixels, or 50 pixels and the signal resulting from fat is shifted along the phase-encoding direction compared to the one resulting from water.

In step 336, the FCN is provided with a TRF size in dependence of the calculated absolute WFS, such that the fat pixels and the physical location of the fat in the EPI images are covered by the TRF. This allows improved identification of fat pixels. In this embodiment the TRF is 50 % larger in phase-encoding direction than the calculated absolute WFS. In other embodiments the TRF size can also be different, e.g., the TRF can for example be at least 50 % larger, at least 40 % larger, or at least 30 % larger in phase-encoding direction than the calculated absolute WFS. The TRF size is adapted by adapting one or more hyperparameters of the FCN such that the TRF is 50 % larger in phase-encoding direction than the absolute WFS, such that the TRF covers the fat pixels and the physical location of the fat in the EPI images. The one or more hyperparameters include one or more of: convolutional kernels, strides, sub-samplings, dilation convolutions, skip connections, and/or types and number of layers of the FCN. In this embodiment the FCN is trained with one TRF. In other embodiments various FCNs can be trained with different TRF sizes or at least one other different hyperparameter.

In step 340, the FCN is trained with the training set of reference fat-only EPI images as input such that the FCN generates EPI images with identified fat pixels as output. In this embodiment an objective function of the FCN is optimized by increasing a similarity between the reference fat-only EPI images of the training set and the EPI images with identified fat pixels generated by the FCN as output. In this embodiment the objective function uses the MSE between the output EPI image of the FCN and the reference fat-only EPI image for representing the similarity of the images. Weights of the FCN are initialized randomly. In other embodiments the weights can also be transferred from another task, or can be provided in any other manner, such as starting with zero weights, or weights that lead to an identity between input image and output image. In this embodiment SGD is used for optimizing the weights of the FCN in order to optimize the objective function. In other embodiments any other optimization method can be used for optimizing the weights of the FCN to optimize the objective function.

Step 350 is only performed if at least two FCNs were trained. Step 350 is optional. In step 350, the trained FCNs are considered for generating the EPI images with identified fat pixels, i.e., it is determined which of the trained FCNs performs optimal for generating the EPI images with identified fat pixels. This allows to determine the FCN optimal for the respective MR sequence used for generating the MR images. In other embodiments a combination of FCNs can be chosen that performs optimal, e.g., by generating an average image based on the images generated by the FCNs.

Fig. 4 shows schematically and exemplarily an embodiment of a method for suppressing fat using a trained FCN in MRI. The trained FCN can for example be the FCN as trained by the method presented in Fig. 3. In this embodiment the trained FCN is optimized for generating EPI images with identified fat pixels based on input EPI images.

In step 400, the trained FCN is provided.

In step 410, an input EPI image is provided as input to the trained FCN.

In step 420, an EPI image with identified fat pixels is generated based on the input EPI image using the FCN.

In step 430 the EPI image with identified fat pixels is subtracted from the input EPI image in order to generate a fat suppressed EPI image.

Step 430 can be followed by the optional step 440 and/or optional steps 450 to 490.

In step 440, the fat suppressed EPI image is displayed to a user. Step 440 can optionally be followed by step 450. In other embodiments step 440 can also be performed in parallel to step 490.

In step 450, EPI scan parameters used for acquiring the EPI image are provided.

In step 460, an absolute WFS is calculated in dependence of the EPI scan parameters.

In step 470, the fat pixels location is shifted in the EPI image with identified fat pixels based on the calculated absolute WFS in order to generate a shifted fat-only EPI image.

In step 480, the shifted fat-only EPI image and the fat suppressed EPI image are added to generate a fat position corrected EPI image.

In step 490, the fat position corrected EPI image is displayed to the user.

While the invention has been illustrated and described in detail in the drawings and foregoing description, such illustration and description are to be considered illustrative or exemplary and not restrictive; the invention is not limited to the disclosed embodiments. For example, it is possible to operate the invention in an embodiment wherein the trained FCN is arranged on a server and MR images are provided to the server in order to be processed on the server. In this case the FCN can generate MR images with identified fat pixels on the server. The server can further run the method for suppressing fat in the MR images and generate fat suppressed MR images based on the MR images with identified fat pixels and the input MR images. The server can provide the MR images with identified fat pixels and/or the fat suppressed MR images to an MRI system or a user device for displaying them to a user.

Other variations to the disclosed embodiments can be understood and effected by those skilled in the art in practicing the claimed invention, from a study of the drawings, the disclosure, and the appended claims.

In the claims, the word "comprising" or "including" does not exclude other elements or steps, and the indefinite article "a" or "an" does not exclude a plurality.

A single unit, processor, or device may fulfill the functions of several items recited in the claims. The mere fact that certain measures are recited in mutually different dependent claims does not indicate that a combination of these measures cannot be used to advantage.

Operations like providing a training set of MR images including fat pixels and corresponding MR images with suppressed fat pixels, training the FCN with the training set as input such that the FCN generates MR images with identified fat pixels as output, providing EPI scan parameters used for acquiring EPI images, calculating an absolute WFS in dependence of the EPI scan parameters, providing the FCN with a TRF size in dependence of the calculated absolute WFS, such that the fat pixels and the physical location of the fat in the EPI images are covered by the TRF, providing an input MR image as input to the trained FCN, generating an MR image with identified fat pixels based on the input MR image using the FCN, subtracting the MR image with identified fat pixels from the input MR image in order to generate a fat suppressed MR image, et cetera performed by one or several units or devices can be performed by any other number of units or devices. These operations and/or the method can be implemented as program code means of a computer program and/or as dedicated hardware.

A computer program may be stored/distributed on a suitable medium, such as an optical storage medium, or a solid-state medium, supplied together with or as part of other hardware, but may also be distributed in other forms, such as via the Internet, Ethernet, or other wired or wireless telecommunication systems.

Any reference signs in the claims should not be construed as limiting the scope.

The present invention relates to training a FCN for identifying fat pixels in MR images and using the trained FCN for suppressing fat in MR images. The FCN is trained with MR images including fat pixels and corresponding MR images with suppressed fat pixels for generating MR images with identified fat pixels as output. The trained FCN generates MR images with identified fat pixels based on input MR images. The MR images with identified fat pixels are subtracted from the input MR images in order to generate fat suppressed MR images. This allows improving the image quality and contrast while not increasing total scan time by efficiently suppressing fat in post processing.

## Claims

1. A method for training a fully convolutional neural network (210) for identifying fat pixels in magnetic resonance images (200) comprising the steps:
- providing a training set of magnetic resonance images including fat pixels (200) and corresponding magnetic resonance images with suppressed fat pixels, and
- training the fully convolutional neural network (210) with the training set as input such that the fully convolutional neural network (210) generates magnetic resonance images with identified fat pixels (220) as output.

2. The method according to claim 1, wherein the magnetic resonance images with suppressed fat pixels are subtracted from the corresponding magnetic resonance images including fat pixels (200) in order to generate a training set of reference fat-only magnetic resonance images, and
wherein an objective function of the fully convolutional neural network (210) is optimized by increasing a similarity between the reference fat-only magnetic resonance images of the training set and the magnetic resonance images with identified fat pixels (220) generated by the fully convolutional neural network (210) as output.

3. The method according to claim 1, wherein the magnetic resonance images with suppressed fat pixels are generated by acquiring the magnetic resonance images with a fat suppression method.

4. The method according to claim 1, wherein the training set includes magnetic resonance images including residual fat pixels that have been generated by a fat suppression method and corresponding magnetic resonance images without fat pixels.

5. The method according to claim 1, wherein the training set includes magnetic resonance images generated by data augmentation and/or artificially generated magnetic resonance images.

6. The method according to claim 1, wherein the training set includes at least two different versions of the same magnetic resonance image with two different resolutions and/or wherein the training set includes magnetic resonance images with different contrasts.

7. The method according to claim 1, wherein the magnetic resonance images are echo-planar images acquired using echo-planar imaging and wherein the method comprises the steps:
- providing echo-planar imaging scan parameters used for acquiring the echo-planar images,
- calculating an absolute water-fat shift in dependence of the echo-planar imaging scan parameters, and
- providing the fully convolutional neural network (210) with a theoretical receptive field size in dependence of the calculated absolute water-fat shift, such that the fat pixels and the physical location of the fat in the echo-planar images are covered by the theoretical receptive field.

8. The method according to claim 7, wherein one or more hyperparameters of the fully convolutional neural network (210) are adapted such that the theoretical receptive field covers the fat pixels and the physical location of the fat in the echo-planar images, and wherein the one or more hyperparameters include one or more of: convolutional kernels, strides, sub-samplings, dilation convolutions, skip connections, and/or types and number of layers of the fully convolutional neural network (210).

9. The method according to claim 7, wherein the theoretical receptive field is at least 50 % larger in phase-encoding direction than the calculated absolute water-fat shift.

10. The method according to claim 7, wherein at least two functional convolutional neural networks (210) are trained with different theoretical receptive field sizes or at least one other different hyperparameter and wherein the at least two functional convolutional neural networks (210) are considered for generating the echo-planar images with identified fat pixels (220).

11. A method for suppressing fat in magnetic resonance images (200), comprising the steps:
- providing an input magnetic resonance image (200) as input to the fully convolutional neural network (210) trained according to the method of claim 1,
- generating a magnetic resonance image with identified fat pixels (220) based on the input magnetic resonance image (200) using the fully convolutional neural network (210),
- subtracting the magnetic resonance image with identified fat pixels (220) from the input magnetic resonance image (200) in order to generate a fat suppressed magnetic resonance image (240).

12. A magnetic resonance image processing product (10) for generating fat suppressed magnetic resonance images (240), comprising:
- a fully convolutional neural network (210) trained according to the method of claim 1, and
- a processor (14) for generating magnetic resonance images with identified fat pixels (220) by applying the fully convolutional neural network (210) on input magnetic resonance images (200), and for subtracting the magnetic resonance images with identified fat pixels (220) from the input magnetic resonance images (200) in order to generate fat suppressed magnetic resonance images (240).

13. A magnetic resonance imaging system (100) for generating fat suppressed magnetic resonance images (240) comprising:
- the magnetic resonance image processing product (10) according to claim 12, and
- a magnetic resonance imaging apparatus (12) configured for generating the input magnetic resonance images (200).

14. A computer program product for generating fat suppressed magnetic resonance images (240), wherein the computer program product comprises program code means for causing a processor (14) to carry out the method as defined in claim 11, when the computer program product is run on the processor (14).

15. A computer readable medium (16) having stored the computer program product of claim 14.
